(19) Europäisches Patentamt
European Patent Office
Office européen des brevets

(11)  EP 1 652 009 B1

(12)  **FASCICULE DE BREVET EUROPEEN**

(45) Date de publication et mention
de la délivrance du brevet:
**07.03.2007 Bulletin 2007/10**

(21) Numéro de dépôt: **04786375.8**

(22) Date de dépôt: **05.08.2004**

(51) Int Cl.:
***G03F 7/20*** (2006.01)

(86) Numéro de dépôt international:
**PCT/FR2004/050377**

(87) Numéro de publication internationale:
**WO 2005/017623 (24.02.2005 Gazette 2005/08)**

(54)  **PROCEDE DE REALISATION DE MOTIFS A FLANCS INCLINES PAR PHOTOLITHOGRAPHIE**

VERFAHREN ZUR HERSTELLUNG VON MUSTERN MIT GENEIGTEN FLANKEN MITTELS FOTOLITHOGRAPHIE

METHOD FOR PRODUCING PATTERNS WITH INCLINED SIDEWALLS BY PHOTOLITHOGRAPHY

(84) Etats contractants désignés:
**CH DE FR GB IT LI**

(30) Priorité: **07.08.2003 FR 0350410**

(43) Date de publication de la demande:
**03.05.2006 Bulletin 2006/18**

(73) Titulaire: **COMMISSARIAT A L'ENERGIE ATOMIQUE**
**75015 Paris (FR)**

(72) Inventeurs:
• **RABAROT, Marc**
**F-38120 Saint Egreve (FR)**
• **KIPP, Mathieu**
**F-67120 Duttlenheim (FR)**
• **KOPP, Christophe**
**F-38240 Meylan (FR)**

(74) Mandataire: **Poulin, Gérard et al**
**Brevatome**
**3, rue du Docteur Lancereaux**
**75008 Paris (FR)**

(56) Documents cités:
DE-A- 19 652 463       GB-A- 1 459 719
US-A- 4 444 616        US-A- 4 912 022
US-A- 5 045 439

• BEURET C ET AL: "Microfabrication of 3D multidirectional inclined structures by UV lithography and electroplating" MICRO ELECTRO MECHANICAL SYSTEMS, 1994, MEMS '94, PROCEEDINGS, IEEE WORKSHOP ON OISO, JAPAN 25-28 JAN. 1994, NEW YORK, NY, USA, IEEE, 25 janvier 1994 (1994-01-25), pages 81-85, XP010207748 ISBN: 0-7803-1833-1 cité dans la demande
• PATENT ABSTRACTS OF JAPAN vol. 2000, no. 02, 29 février 2000 (2000-02-29) & JP 11 327154 A (MITSUBISHI ELECTRIC CORP), 26 novembre 1999 (1999-11-26)
• MANHEE HAN ET AL: "Fabrication of 3D microstructures with inclined/rotated UV lithography" PROCEEDINGS OF THE IEEE 16TH. ANNUAL INTERNATIONAL CONFERENCE ON MICROELECTRO MECHANICAL SYSTEMS. MEMS 2003. KYOTO, JAPAN, AN. 19 - 23, 2003, IEEE INTERNATIONAL MICRO ELECTRO MECHANICAL SYSTEMS CONFERENCE, NEW YORK, NY: IEEE, US, vol. CONF. 16, 19 janvier 2003 (2003-01-19), pages 554-557, XP010637032 ISBN: 0-7803-7744-3
• FEIERTAG G ET AL: "SLOPED IRRADIATION TECHNIQUES IN DEEP X-RAY LITHOGRAPHY FOR 3-D SHAPING OF MICROSTRUCTURES" PROCEEDINGS OF THE SPIE, SPIE, BELLINGHAM, VA, US, vol. 3048, 1997, pages 136-145, XP008013116 ISSN: 0277-786X
• LIN B J: "OPTICAL MANIPULATION OF RESIST PROFILE IN CONFORMABLE PRINTING" JOURNAL OF VACUUM SCIENCE AND TECHNOLOGY, NEW YORK, NY, US, vol. 15, no. 3, mai 1978 (1978-05), pages 1012-1015, XP008027333 ISSN: 0022-5355

# Description

## DOMAINE TECHNIQUE

La présente invention concerne un procédé de photolithographie sous incidence contrôlée pour la fabrication de micro-composants ou micro-systèmes et un dispositif permettant de mettre en oeuvre le procédé.

La photolithographie est utilisée dans la fabrication des circuits intégrés, elle est aussi la technique de base permettant la fabrication de micro-structures comme des MEMS (abréviation anglo-saxonne de "Micro Electro Mechanical Systems" soit micro-systèmes electro-mécaniques). Elle consiste à fabriquer des motifs prédéfinis sur un substrat approprié (par exemple une tranche de silicium) pour pouvoir modifier localement les propriétés de ce substrat (ce qui permet par exemple de réaliser des transistors) ou déposer du métal à certains endroits sur le substrat pour réaliser par exemple des micro-machines.

## ETAT DE LA TECHNIQUE ANTERIEURE

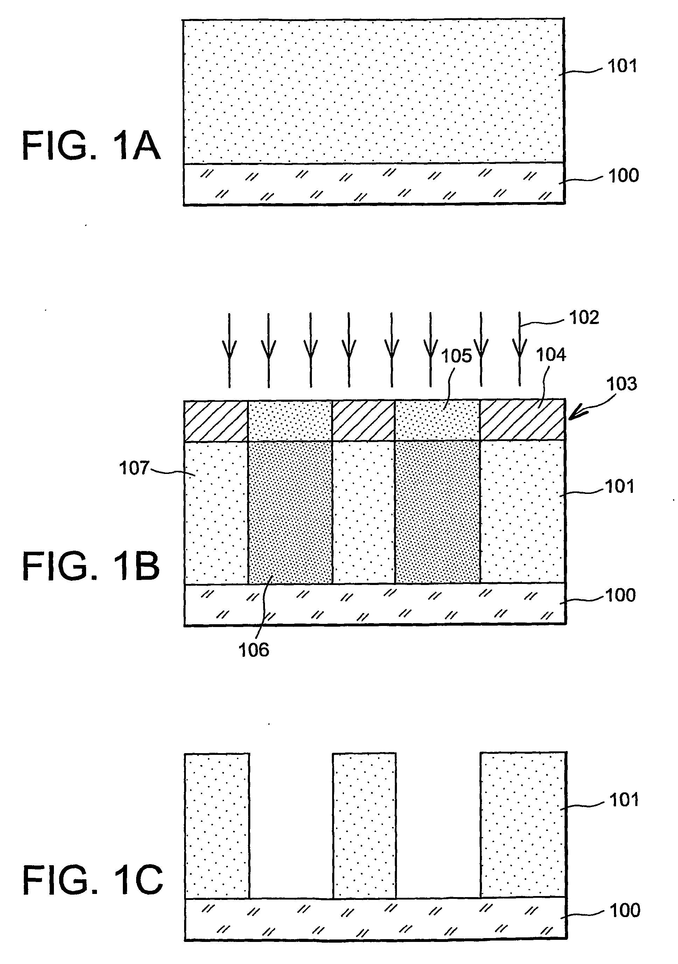

Classiquement, un procédé de photolithographie se fait sous incidence normale (c'est à dire qu'une couche de résine à photo-structurer est habituellement perpendiculaire à la direction principale d'un faisceau de rayons lumineux par lequel on l'insole). On dépose lors d'une première étape, une couche de résine photosensible 101 (par exemple d'une centaine de micromètres de polyimide) sur un substrat 100 (par exemple en silicium) (figure 1A). On expose ensuite cette couche de résine photosensible 101 pour y réaliser des motifs, à l'aide d'un faisceau de rayons lumineux 102 (généralement de longueur d'onde située dans le domaine de l'ultra-violet) orthogonal au plan principal de la couche de résine 101 à travers un masque 103 comportant des parties opaques 104 (par exemple en métal) au faisceau de rayon lumineux 102 et des parties transparentes 105 (par exemple en silice) au faisceau de rayons lumineux 102, les parties transparentes 105 pouvant être des trous. Les parties transparentes 105 sont disposées selon les motifs que l'on souhaite réaliser. L'image du masque 103 est alors projetée sur la couche de résine photosensible 101. Certaines parties de la couche de résine 101 subissent à ce moment l'exposition aux rayons ultra-violets alors que d'autres restent intactes. La couche de résine 101 comprend donc des zones insolées 106 et des zones non-insolées 107 correspondant aux parties de la couche de résine 101 protégées par le masque 103 (figure 1B). Enfin, on retire le masque 103, puis la couche de résine 101 est développée avec des produits chimiques tels que par exemple une base forte, qui enlèvent les zones insolées 106 de la couche de résine 101 et laissent les zones non-insolées 107 dans le cas où la résine de la couche de résine 101 est un résine de type "positive" (figure 1C).

Aujourd'hui avec l'avènement des micro-techniques, on cherche à obtenir des micro-structures de formes de plus en plus complexes. Pour cela, on doit réaliser parfois, lors des procédés de photolithographie, des motifs de résine à flancs inclinés dans une couche de résine photosensible. Un exemple de procédé pour réaliser des motifs de résine à flancs inclinés consiste tout d'abord à déposer une couche de résine photosensible 101 sur un substrat 100 comme illustré sur la figure 1A. La couche de résine photosensible 101 a un indice de réfraction $N_2$. On accole un masque 103 à cette couche de résine 101. Le masque 103, possède des parties opaques 104 par exemple en chrome et des parties transparentes 105 par exemple en silice d'indice de réfraction $N_1$. Ensuite, le substrat 100 recouvert de la couche de résine photosensible 101 et du masque 103 forment un ensemble que l'on incline sous un faisceau de rayons lumineux 102 ultra-violets de direction principale $\vec{d}_1$.

Le faisceau de rayons lumineux 102 traverse une couche d'air d'indice de réfraction $N_0$ environ égal à 1 et réalise un angle d'incidence $\hat{I}_1$ sur le masque 103 par rapport à une normale $\vec{n}$ au plan principal du substrat 100 avant de pénétrer à travers les parties transparentes 105 du masque 103. Le faisceau de rayons lumineux 102 est ensuite réfracté lorsqu'il passe à travers les parties transparentes 105 du masque 103. La direction principale $\vec{d}_1$ du faisceau 102 est alors déviée et réalise un angle incident $\hat{R}_1$ sur la couche de résine 101 avec une normale $\vec{n}$ au plan principal du substrat 100 au moment où le faisceau s'apprête à traverser la couche de résine photosensible 101. L'angle incident $\hat{R}_1$ sur la couche de résine 101 est inférieur à l'angle d'incidence $\hat{I}_1$ sur le masque 103 puisque le faisceau passe de l'air vers un milieu plus réfringent ($N_1 > N_0$). Le faisceau de rayons lumineux 102 pénètre ensuite à travers la couche de résine photosensible 101 d'indice de réfraction $N_2$. Le faisceau de rayons lumineux 102 est alors à nouveau réfracté. Dans la couche de résine photosensible 101, la direction principale $\vec{d}_1$ du faisceau 102 réalise avec la normale $\vec{n}$, un angle résultant d'insolation $\hat{R}_2$ fonction de l'angle incident $\hat{R}_1$, de $N_2$ et de $N_1$ (figure 2A). La couche de résine photosensible 101 est donc insolée par un faisceau de rayons lumineux 102 incliné et réalisant un angle résultant d'insolation $\hat{R}_2$ avec la normale $\vec{n}$ au plan principal du substrat 100.

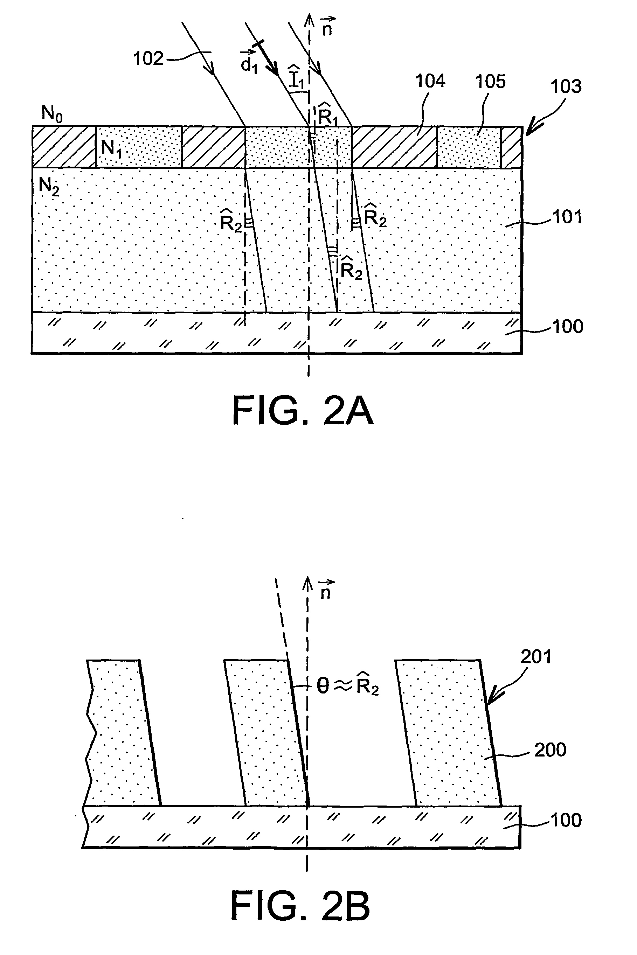

Ensuite, le masque 103 est ôté de la couche de résine photosensible 101. Puis, la couche de résine photosensible 101 est développée, par exemple à l'aide d'une base forte. Après développement, on obtient des motifs de résine 200 à flancs inclinés 201 (figure 2B). Les flancs inclinés 201 des motifs 200 forment un angle

$\theta$ avec une normale $\vec{\mathbf{n}}$ au plan principal du substrat 100, environ égal à l'angle résultant d'insolation $\hat{\vec{\mathbf{R}}}_2$.

Avec ce procédé de réalisation de motifs de résine 200 à flancs inclinés 201, l'angle $\theta$ des flancs 201 des motifs 200 est fortement limité. En effet, lors de l'étape d'insolation, le faisceau de rayons lumineux 102 traverse tout d'abord inévitablement une couche d'air d'indice $N_0$, puis un masque d'indice $N_1$ environ égal à 1,45 par exemple pour un masque en silice, puis une couche de résine photosensible 101 d'indice de réfraction environ égal à 1,6 (1,67 pour une couche de résine 101 de type SU-8). L'importante différence d'indice de réfraction entre la couche d'air et le masque 103 et la différence d'indice de réfraction entre le masque 103 et la couche de résine photosensible 101, entraînent un écart important entre l'angle d'incidence $\hat{\mathbf{I}}_1$ sur le masque 103 et l'angle résultant d'insolation $\hat{\mathbf{R}}_2$. Même lorsqu'on insole la couche de résine photosensible 101 avec un angle d'incidence $\hat{\mathbf{I}}_1$ sur le masque 103 élevé, l'angle résultant d'insolation $\hat{\mathbf{R}}_2$ reste faible. Par ailleurs, à partir d'une certaine valeur de $\hat{\mathbf{I}}_1$, on se heurte en plus à des problèmes de réflexion du faisceau 102 sur le masque 103.

Après développement de la couche de résine photosensible 101, l'angle $\theta$ des flancs 201 de motifs 200 (environ égal à $\hat{\mathbf{R}}_2$) que réalisent les flancs inclinés 201 des motifs de résine 200 avec la normale $\vec{\mathbf{n}}$ est donc lui aussi limité.

La limitation de l'angle $\theta$ des motifs de résine 200, est très pénalisante. Elle empêche de pouvoir fabriquer de nombreuses micro-structures. La réalisation par exemple de micro-prismes à angles de 45° est impossible avec un tel procédé.

En plus de la limitation de l'angle $\theta$ des motifs de résine 200, d'autres problèmes apparaissent avec le procédé illustré à la figure 2A. Tout d'abord celui des réflexions de Fresnel entre le masque 103 et la couche de résine photosensible 101. Les réflexions de Fresnel sont dues à une fine couche d'air se trouvant inévitablement entre le masque 103 et la couche de résine photosensible 101. Elles peuvent entraîner notamment une mauvaise définition des motifs de résine 200 après l'étape de développement de la couche de résine photosensible.

Une solution permettant de diminuer les réflexions de Fresnel est décrite dans le document [1] référencé à la fin de la présente description.

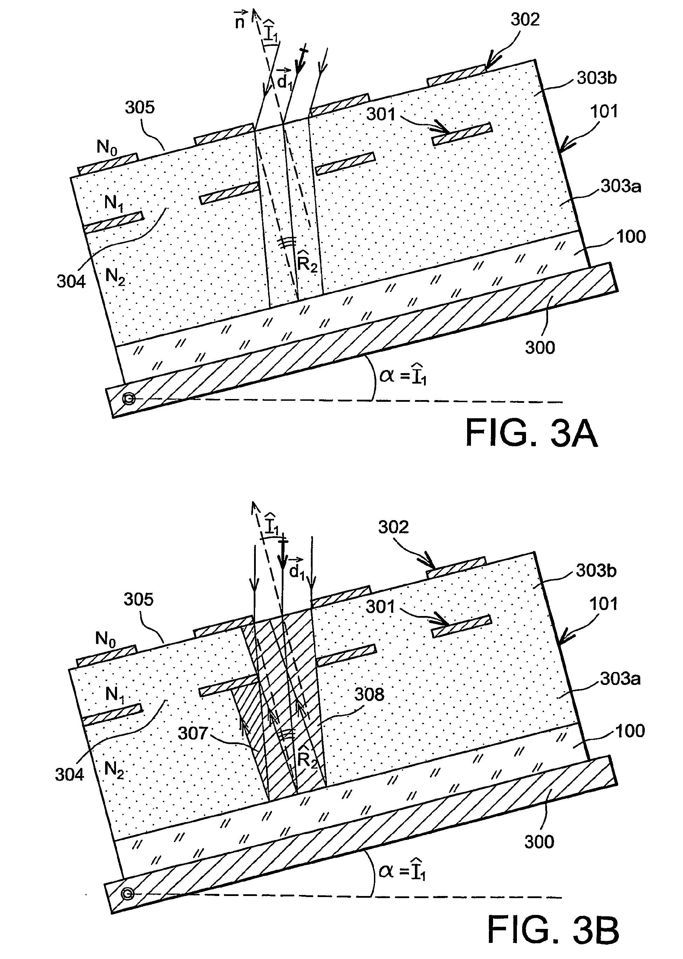

Lors de l'étape d'insolation illustrée par la figure 3A, on incline tout d'abord d'un angle $\alpha$, un substrat 100 recouvert d'une couche de résine photosensible 101, sous un faisceau de rayons lumineux 102 ultra-violet de direction principale $\vec{\mathbf{d}}_1$ à l'aide d'un plateau 300 inclinable sur lequel repose le substrat 100. La couche de résine photosensible 101 est insolée au travers de deux masques 301,302 intégrés directement à la couche de résine photosensible 101. La couche de résine photosensible est composée d'une sous-couche de base 303a d'indice de réfraction $N_2$ qui repose sur le substrat 100 et d'une sous couche intermédiaire 303b située au dessus de la sous-couche de base 303a et d'indice de réfraction $N_1$ égal à $N_2$. Les masques 301,302 sont composés chacun d'une couche métallique en titane ou en aluminium séparées entre elles par la sous-couche de résine photosensible intermédiaire 303b. Le masque 301 comprend des ouvertures 304. Le masque 302 comprend des ouvertures 305 identiques mais décalées latéralement légèrement par rapport aux ouvertures 304.

La direction principale $\vec{\mathbf{d}}_1$ du faisceau 102 réalise un angle d'incidence $\hat{\mathbf{I}}_1$ sur le masque 301 avec une normale $\vec{\mathbf{n}}$ au plan principal du substrat 100 égal à l'angle d'inclinaison $\alpha$, avant de pénétrer à travers la couche de résine photosensible 101. Lorsque le faisceau 102 traverse la couche de résine photosensible 101, il est réfracté et sa direction principale $\vec{\mathbf{d}}_1$ réalise un angle résultant d'insolation $\hat{\vec{\mathbf{R}}}_2$ avec la normale $\vec{\mathbf{n}}$ au plan principal du substrat 100. La couche de résine photosensible 101 est donc exposée selon un angle résultant d'insolation $\hat{\vec{\mathbf{R}}}_2$.

Dans cet exemple, les masques 301,302 étant intégrés à la couche de résine photosensible 101, les réflexions parasites, par exemple de type réflexions de Fresnel, sont supprimées puisqu'il n'y a plus de couche d'air entre masque et résine.

Le fait d'intégrer les masques 302,303 directement à la couche de résine photosensible 101 permet donc d'obtenir des motifs de meilleure résolution qu'avec l'exemple de procédé décrit par la figure 2A.

Le procédé de réalisation de motifs à flancs inclinés illustré par la figure 3A présente encore plusieurs inconvénients.

Tout d'abord, le mode de réalisation des masques 302,303 implique que ce procédé n'est valable que pour réaliser des motifs simples et de taille relativement élevés (de l'ordre de la dizaine de micromètres), d'autre part il nécessite des étapes supplémentaires de photolithographie pour réaliser les masques 302,303 intégrés à la couche de résine 101 par rapport à celui illustré à la figure 2A.

De plus, la technique de réalisation de motifs à flancs inclinés par photolithographie illustrée par la figure 3A présente en toujours l'inconvénient que l'angle d'inclinaison $\theta$ des flancs inclinés des motifs de résine reste limité.

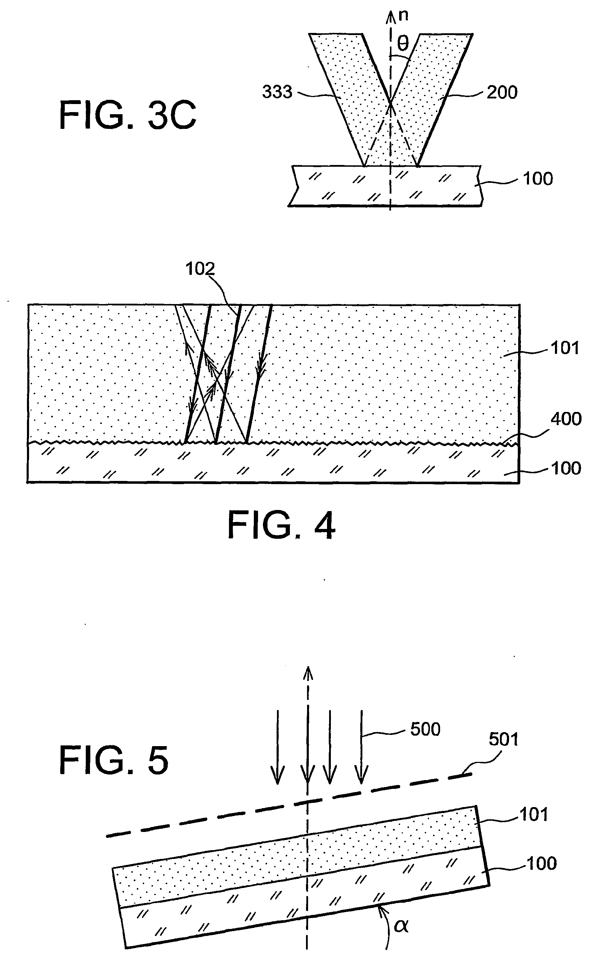

Un autre problème se pose lors des étapes d'insolation des deux procédés illustrés précédemment par les figures 2A et 3A. Il est lié aux réflexions du faisceau de rayon lumineux 102 sur le substrat 100. En effet, après avoir traversé la couche de résine photosensible 101, une partie du faisceau de rayons lumineux 102 peut être réfléchie sur le substrat 100 et former ainsi des zones d'insolation parasites 307 en dehors de zones d'insolation souhaitées 308 (figure 3B). Les zones d'insolation parasites 307 peuvent ainsi conduire à la formation de motifs de résine parasites 333 s'ajoutant aux motifs de résine 200 souhaités (figure 3C).

Le document [2] référencé à la fin de la présente description propose une méthode pour réduire les problèmes de réflexion sur le substrat 100. Avant l'étape de dépôt de la couche de résine photosensible 101, le substrat 100 est soumis à un jet de sable de pression de 300 à 500 kPa avec des grains de SiC. Ce jet de sable sert à rendre la surface 400 du substrat 100 rugueuse. Ainsi, lors de la phase d'insolation de la couche de résine photosensible 101, les réflexions du faisceau de rayon lumineux 102 sur le substrat 100 deviennent irrégulières ce qui entraîne une réduction des zones d'insolation parasites (figure 4). Néanmoins cette méthode a pour inconvénient qu'elle ne supprime pas totalement les réflexions parasites, puisqu'elle diminue le temps d'exposition de la couche de résine de couche d'adaptation d'indice entre le masque et la couche de résine.

Le procédé décrit dans ce document [3] permet donc de résoudre le problème des réflexions sur le substrat et des "réflexions de Fresnel" qui apparaissent pour des procédés de photolithographie à faisceau de rayons inclinés. En revanche, il n'apporte pas de solution à la limitation de l'angle des motifs de résine que l'on peut fabriquer.

Le document US 2001/008741 décrit l'insolation à travers du substrat utilisant un système optique qui permet d'utiliser un appareil standard pour l'insolation inclinée pour la fabrication de microcomposants.

Il est connu de pouvoir réaliser des micro-structures tridimensionnelles avec des flancs inclinés en utilisant une technique de photolithographie à base de rayons X. Par exemple, la technique LIGA (LIGA pour "Lithographie Galvaniesirung und Abformung" soit lithographie finie par galvanisation) consiste à exposer une couche de résine photosensible, par exemple un polymère de type PMMA (PMMA pour polylméthyl methacrylate) à l'aide de rayons X provenant d'un synchrotron. La couche de résine photosensible est ensuite développée. Des motifs de résine de bonne définition sont ainsi formés. Pour obtenir des motifs de résine à flancs inclinés, à l'aide d'un procédé de photolithographie par rayons X, on peut utiliser une méthode dérivée de la méthode LIGA et décrite dans les documents [4] et [5] référencés à la fin de la présente description. Cette méthode décrite à la figure 5 consiste à réaliser plusieurs expositions d'un substrat 100 recouvert d'une couche de résine photosensible 101 et d'un masque 501 en gardant l'ensemble masque 501-subtrat 100 incliné par rapport à un faisceau de rayons X 500 incident provenant d'un synchrotron (non dans les zones d'insolation parasites en orientant les rayons lumineux réfléchis dans des directions très diverses.

Le document [3] référencé à la fin de la présente description propose un autre procédé utilisant une méthode permettant notamment de réduire les problèmes de réflexion sur le substrat. Cette méthode consiste à coupler plusieurs filtres polariseurs à une source de rayons lumineux pour insoler une couche de résine photosensible reposant sur un substrat, à l'aide d'un faisceau de rayons lumineux, le faisceau étant incliné par rapport au substrat. L'emploi d'un filtre polariseur circulaire couplé à un filtre polariseur rectiligne permet de diminuer significativement les problèmes de réflexion sur le substrat.

Le document [3] présente également une méthode (non illustrée) pour réaliser des motifs de résine incurvés grâce à l'utilisation d'un "shadow mask" (ou "masque à ombre"). Le " masque à ombre " est un masque comprenant des parties opaques et des parties transparentes. Les parties transparentes du "masque à ombre" ont la particularité d'être recouvertes de monticules courbes en polymère. Ce sont ces monticules, placés sur les parties transparentes du masque qui permettent d'obtenir des motifs de résine incurvés. Le document [3] présente également l'utilisation d'une couche de glycérol entre le "shadow mask" et le substrat recouvert de résine pour remplacer la couche d'air se trouvant inévitablement entre le "shadow mask" et la couche de résine. La couche de glycérol sert donc représenté). Contrairement aux rayons ultra-violets, les rayons X sont très peu réfractés lorsqu'ils pénètrent à travers la couche de résine photosensible 501. Les rayons X permettent donc d'obtenir des motifs de résine ayant un angle d'inclinaison par rapport à une normale à un plan principal du substrat supérieur à celui obtenu par les techniques classiques utilisant les rayons utra-violets. Mais la photolithographie par rayons X comporte néanmoins d'importants inconvénients. Un premier inconvénient associé à l'utilisation de cette technique vient du fait que les sources de rayons X (synchrotrons) utilisées pour mettre en oeuvre la photolithographie par rayons X sont très coûteuses et très encombrantes. Les masques utilisés en photolithographie par rayons X sont également très coûteux. Enfin, la photolithographie par rayons X à cause de son coût et de sa difficulté de mise en oeuvre n'est pour l'instant pas utilisée au niveau industriel dans des procédés de fabrication de circuits intégrés.

**EXPOSÉ DE L'INVENTION**

La présente invention a pour but de proposer un procédé de réalisation de motifs par photolithographie ainsi qu'un dispositif de réalisation de ce procédé. Le procédé ainsi que le dispositif sont simples à mettre en oeuvre et de coût réduit, contrairement aux techniques de photolithographie par rayons X. La présente invention permet de réaliser des motifs par photolithographie ayant des flancs inclinés réalisant un angle bien supérieur à ceux que l'on peut obtenir avec l'art antérieur. La présente invention concerne également un dispositif ainsi qu'un procédé qui permettent de s'affranchir des problèmes de réflexions parasites qui surviennent, avec certains procédés classiques de photolithographie à faisceau de rayons lumineux incliné.

Pour atteindre ces buts, la présente invention concerne un procédé de réalisation d'un ou plusieurs motifs par photolithographie comprenant les étapes suivantes :

a) dépôt sur un substrat d'une couche de résine photosensible,

ledit procédé est caractérisé en ce qu'il comprend les étapes suivantes :

b) insolation de la couche de résine photosensible à travers un masque par un faisceau de rayons lumineux ayant une direction principale, le faisceau de rayons lumineux ayant traversé auparavant un système optique, qui dévie la direction principale du faisceau de rayons lumineux d'un angle de déviation prédéterminé de sorte que la direction principale présente un angle d'incidence sur le masque non nul avec une normale au plan principal du substrat lorsque le faisceau de rayons lumineux pénètre à travers le masque,

c) retrait du masque,

d) développement de la couche de résine photosensible de façon à obtenir les motifs à flancs inclinés par rapport à une normale au plan principal du substrat en fonction de l'angle de déviation prédéterminé.

La présente invention concerne également un procédé de réalisation d'un ou plusieurs motifs par photolithographie comprenant les étapes suivantes :

a) dépôt sur un substrat d'une couche de résine photosensible,

ledit procédé étant caractérisé en ce qu'il comprend les étapes suivantes :

b) insolation de la couche de résine photosensible à travers un masque accolé à ladite couche de résine photosensible ou à une couche d'adaptation d'indice accolée à ladite couche de résine, par un faisceau de rayons lumineux ayant une direction principale, le faisceau de rayons lumineux ayant traversé auparavant un système optique accolé audit masque ou à une couche d'adaptation d'indice accolée audit masque, le système optique déviant la direction principale du faisceau de rayons lumineux d'un angle de déviation prédéterminé de sorte que la direction principale présente un angle d'incidence sur le masque non nul avec une normale au plan principal du substrat lorsque le faisceau de rayons lumineux pénètre à travers le masque,

c) retrait du masque,

d) développement de la couche de résine photosensible de façon à obtenir les motifs à flancs inclinés par rapport à une normale au plan principal du substrat en fonction de l'angle de déviation prédéterminé.

Selon une caractéristique particulièrement avantageuse du procédé, l'étape de dépôt de la couche de résine photosensible peut être précédée d'une étape de dépôt d'au moins une couche absorbante de rayons lumineux. Ainsi, en déposant une couche absorbante de rayons lumineux juste avant la couche de résine photosensible, on peut limiter les réflexions du faisceau de rayons lumineux sur le substrat et éviter ainsi une insolation parasite de la couche de résine photosensible.

Selon une caractéristique particulièrement utile du procédé, après l'étape a) de dépôt de la couche de résine photosensible, une couche d'adaptation d'indice peut être déposée sur la couche de résine photosensible.

Ainsi, on peut déposer entre la couche de résine photosensible et le masque par exemple en silice, une couche d'adaptation d'indice sous forme généralement de liquide ou de gel choisie en fonction du saut d'indice entre le masque et la couche de résine photosensible. La couche d'adaptation d'indice a un indice de réfraction, supérieur à celui de l'air et de préférence compris entre l'indice de réfraction du masque et l'indice de réfraction de la couche de résine photosensible. Cette couche d'adaptation permet ainsi de supprimer les réflexions de Fresnel entre le masque et la couche de résine, et à l'étape d) d'obtenir des angles d'inclinaison des flancs des motifs de résine supérieurs à ceux obtenus dans l'art antérieur.

Selon une caractéristique particulièrement intéressante du procédé, avant l'étape d'insolation de la couche de résine photosensible, une couche d'adaptation d'indice est placée entre le système optique et le masque.

Ainsi, de même qu'on dépose une couche d'adaptation d'indice entre la couche de résine photosensible et le masque, on peut, avant l'étape d'insolation, placer une couche d'adaptation d'indice entre le masque et le système optique. Cette deuxième couche d'adaptation d'indice se présente par exemple sous forme d'un gel ou d'un liquide déposé sur le masque et qui se diffuse par capillarité entre le système optique et le masque accolé.

Cette couche d'adaptation permet ainsi de supprimer les réflexions de Fresnel entre le système optique et le masque, et à l'étape d) d'obtenir des angles d'inclinaison des flancs des motifs de résine supérieurs à ceux obtenus dans l'art antérieur.

Selon une caractéristique particulièrement avantageuse du procédé selon l'invention, le système optique peut comprendre un prisme, un réseau de diffraction, un réseau de micro-prismes ou un diffuseur optique.

Ainsi, un prisme, un réseau de diffraction, un réseau de micro-prismes ou un diffuseur optique sont des systèmes optiques aptes, lors de la phase d'insolation à dévier la direction principale du faisceau de rayons lumineux d'un angle de déviation prédéterminé de sorte qu'il présente un angle d'incidence sur le masque non nul avec une normale au plan principal du substrat lorsqu'il pénètre à travers le masque.

Selon une caractéristique particulièrement avantageuse du procédé, pendant l'étape d'insolation, l'angle d'incidence sur le masque peut varier.

Ainsi, par exemple en faisant varier l'inclinaison du système optique par rapport à la direction principale du faisceau de rayons lumineux, on peut faire varier l'angle d'incidence sur le masque que réalise la direction principale du faisceau de rayons lumineux avec une normale au plan principal du substrat. On peut de cette manière faire varier l'angle résultant d'insolation de la couche de résine photosensible et obtenir de cette façon, après développement, des motifs de résine avec des flancs ayant un angle d'inclinaison variable.

Selon une caractéristique particulièrement utile du procédé, pendant l'étape b) d'insolation, d'une part le système optique et d'autre part le substrat peuvent être animés d'un mouvement relatif l'un par rapport à l'autre, le masque étant associé soit au système optique, soit au substrat.

Ainsi, le système optique, par exemple un prisme, peut rester fixe alors qu'un ensemble formé par le substrat, la couche de résine photosensible et le masque tourne sur lui-même. Cela peut permettre d'obtenir des motifs de résine avec des flancs inclinés dans différentes directions. Le système optique, par exemple un réseau de diffraction, peut tourner sur lui-même alors qu'un ensemble formé par le masque, le substrat, la couche de résine photosensible reste fixe. Enfin, le masque associé au système optique peut également tourner sur lui même alors que le substrat recouvert de la couche de résine photosensible reste fixe. En faisant tourner le système optique et/ou le masque par rapport au substrat, on peut obtenir des motifs de résine avec des flancs non-nécessairement plans et inclinés dans différentes directions.

Selon une caractéristique particulièrement intéressante du procédé, pendant l'étape b) d'insolation, un ensemble formé du système optique, du masque, et du substrat peut être animé d'un mouvement relatif par rapport au faisceau de rayons lumineux.

Ainsi, un ensemble formé par le système optique, par exemple un prisme, par le substrat, la couche de résine photosensible peut être fixe alors que la direction principale du faisceau de rayon lumineux varie. Cela peut permettre d'obtenir des motifs de résine d'inclinaison variable.

L'invention concerne également un dispositif de réalisation d'un ou plusieurs motifs inclinés par photolithographie, comportant un plateau sur lequel repose un substrat, sur lequel repose une couche de résine photosensible, un masque, des moyens pour insoler la couche de résine photosensible à l'aide d'un faisceau de rayons lumineux ayant une direction principale, le faisceau de rayons lumineux traversant un système optique déviant d'un angle de déviation prédéterminé la direction principale du faisceau de rayons lumineux de sorte que la direction principale du faisceau présente un angle d'incidence sur le masque non nul avec une normale au plan principal du substrat au moment où le faisceau de rayons lumineux pénètre à travers le masque.

L'invention concerne en outre un dispositif de réalisation d'un ou plusieurs motifs inclinés par photolithographie comprenant un substrat sur lequel repose une couche de résine photosensible, le dispositif comportant en outre un masque d'indice de réfraction accolé à ladite couche de résine photosensible ou à une couche d'adaptation d'indice reposant sur ladite couche de résine, un système optique accolé au masque ou à une couche d'adaptation d'indice reposant sur le masque, des moyens pour insoler la couche de résine photosensible à l'aide d'un faisceau de rayons lumineux ayant une certaine direction principale, le système optique étant apte à dévier d'un angle de déviation prédéterminé la direction principale du faisceau, de sorte que la direction principale du faisceau de rayons lumineux présente un angle d'incidence sur le masque non nul avec une normale au plan principal du substrat au moment où le faisceau de rayons lumineux pénètre à travers le masque.

Le masque du dispositif comporte une ou plusieurs ouvertures. Selon une caractéristique particulièrement intéressante du dispositif, le système optique et les ouvertures du masque peuvent avoir des indices de réfraction proches.

Selon une caractéristique particulièrement intéressante du dispositif, le système optique et les ouvertures du masque peuvent être réalisés dans le même matériau.

Ainsi, on cherche à limiter le saut d'indice de réfraction entre le système optique et le masque et donc à limiter la déviation du faisceau de rayons lumineux lorsque le faisceau de rayons lumineux sort du système optique et pénètre à travers le masque.

Selon une caractéristique particulièrement avantageuse du dispositif, le masque est intégré à la couche de résine photosensible.

Ainsi, le masque peut être constitué d'une couche métallique gravée intégrée dans la couche de résine photosensible de manière à ce qu'il n'y ait pas de réfraction lorsque le faisceau de rayons lumineux passe du masque à la couche de résine photosensible. De plus, les réflexions de Fresnel entre le masque et la couche de résine sont ainsi supprimées.

Selon une caractéristique particulièrement utile du dispositif, le système optique peut comprendre un prisme, un réseau de diffraction, un réseau de micro-prismes ou un diffuseur optique. Ainsi, le prisme, le réseau de diffraction, le diffuseur optique, le réseau de micro-prismes permettent d'insoler une couche de résine photosensible à photo-structurer posée sur un substrat à l'aide d'un faisceau de rayons lumineux incliné par rapport à une normale au plan principal du substrat, même lorsque le faisceau de rayon lumineux traverse le prisme, le réseau de diffraction, le réseau de micro-prismes ou le diffuseur optique selon une incidence normale.

Selon une caractéristique particulièrement intéressante du dispositif, le dispositif peut comprendre une couche d'adaptation d'indice entre la couche de résine photosensible et le masque.

Une couche d'adaptation d'indice entre la couche de résine photosensible et le masque permet de remplacer une fine couche d'air se trouvant inévitablement à l'interface entre la couche de résine photosensible et le masque et limite ainsi les réflexions de Fresnel du faisceau de rayons lumineux à l'interface entre la couche de résine photosensible et le masque.

Selon une caractéristique particulièrement avantageuse du dispositif, le dispositif comprend une couche d'adaptation d'indice entre le masque et le système optique.

Une couche d'adaptation d'indice entre le masque et le système optique, permet de remplacer une fine couche d'air se trouvant inévitablement à l'interface entre le masque et le système optique et permet de limiter ainsi les réflexions de Fresnel du faisceau de rayons lumineux à l'interface entre le masque et le système optique.

Selon une caractéristique particulièrement intéressante du dispositif la couche d'adaptation située entre la couche de résine photosensible et le masque ou/et la couche d'adaptation située entre le système optique et le masque peut être un liquide tel que l'eau ou un fluide gras.

Selon une caractéristique particulièrement utile du dispositif, le dispositif comprend une couche absorbante de rayons lumineux entre le substrat et la couche de résine photosensible.

Ainsi, une couche absorbante de rayons ultra violets située juste au dessous de la couche de résine photosensible à photo-structurer permet de limiter les réflexions parasites sur une couche située sous la couche de résine photosensible lors de l'étape d'exposition. Ces réflexions parasites, apparaissent lorsque le faisceau de rayons lumineux incident à la résine est incliné par rapport à une normale au plan principal du substrat. Les réflexions parasites créent alors des zones d'exposition parasites dans la couche de résine photosensible et peuvent créer des motifs de résine parasites après développement de la couche de résine photosensible.

Selon une caractéristique particulièrement utile du dispositif, le système optique est mobile relativement au substrat, le masque étant associé soit au système optique, soit au substrat.

Ainsi un plateau sur lequel se trouve le substrat peut être en mouvement et donc par exemple permettre de faire tourner sur lui même un ensemble formé par le substrat, la couche de résine photosensible et le masque alors que le système optique reste fixe.

Selon une caractéristique particulièrement utile du dispositif selon l'invention, il peut comprendre un plateau sur lequel repose le substrat, mobile en rotation par rapport au faisceau de rayons lumineux.

Selon une caractéristique particulièrement profitable du dispositif selon l'invention il peut comprendre un plateau sur lequel repose le substrat, inclinable par rapport au faisceau de rayons lumineux.

On peut bien entendu combiner les mouvements du plateau et faire varier l'inclinaison du plateau alors qu'il est mobile en rotation

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

les figures 1A-1C, déjà décrites représentent des exemples de procédé de photolithographie selon l'art connu ;

les figures 2A-2B,3A-3C,4,5 déjà décrites représentent un exemple de procédé de photolithographie qui permet la réalisation de motifs de résine par photolithographie à flancs inclinés selon l'art connu ;

les figures 6A-6C, 7, 8, 9, 10A, 10B, 11A, 11B, 12, représentent des exemples de procédé de photolithographie pour la réalisation d'un ou plusieurs motifs de résine avec des flancs inclinés selon l'invention ;

les figures 13A-13E représentent des exemples de dispositifs pour la réalisation d'un ou plusieurs motifs à flancs inclinés par photolithographie selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

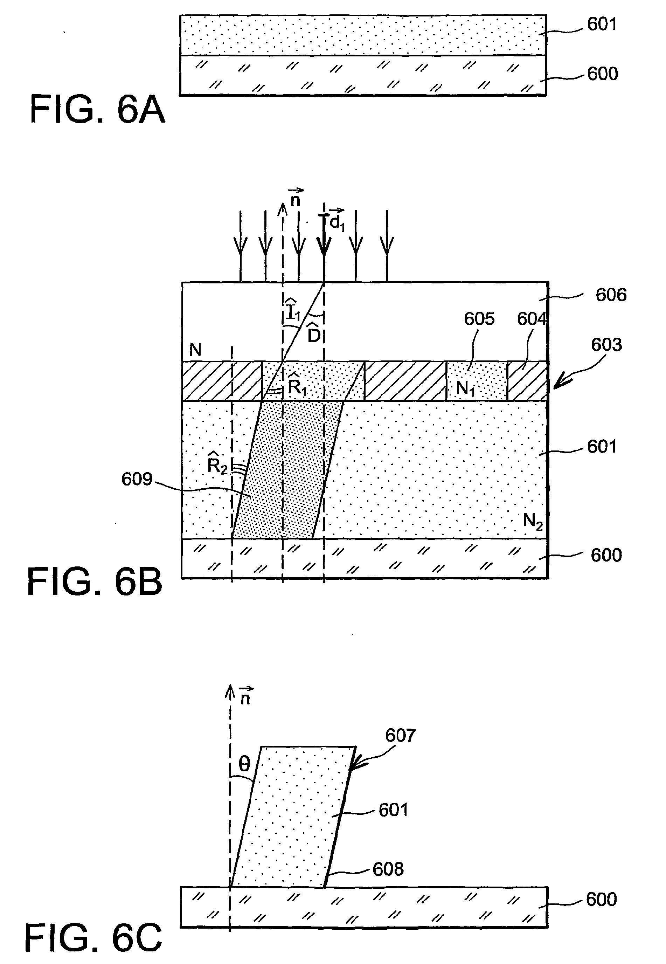

Un premier exemple de procédé de réalisation d'un ou plusieurs motifs par photolithographie, à flancs inclinés, selon l'invention, est illustré par les figures 6A-6C.

La première étape de ce procédé illustrée par la figure 6A consiste à déposer une couche de résine photosensible 601 sur un substrat 600. La couche de résine photosensible 601, par exemple une couche de résine photosensible négative à base époxy telle que celle commercialisée par la société Micro-Chemical Corporation sous la référence "SU-8" est déposée par un procédé classique et possède une épaisseur par exemple d'environ 100 $\mu$m. Le substrat 600 est par exemple en verre, en silicium, etc.

Ensuite, lors d'une étape décrite par la figure 6B, on accole un masque 603 à la couche de résine photosensible 601, puis on accole au dessus du masque 603 un système optique 606 d'indice de réfraction N. Le masque 603 comprend des zones opaques 604 à la lumière, par exemple en métal tel que le chrome, et des zones transparentes 605 à la lumière par exemple en silice. On insole ensuite la couche de résine photosensible 601 d'indice de réfraction $N_2$ à travers le masque 603 d'indice de réfraction $N_1$. L'insolation est réalisée par un faisceau de rayons lumineux 602 provenant par exemple d'une source à rayons ultra-violets (non représentée sur la figure) émettant par exemple autour de la longueur d'onde de 365 nm. Le faisceau de rayons lumineux 602 a une direction principale $\vec{d}_1$ et pénètre, en incidence normale, à travers le système optique 606 d'indice de réfraction N, accolé au masque 603. Le système optique 606 dévie la direction principale $\vec{d}_1$ du faisceau optique 603 d'un angle de déviation $\hat{D}$. L'angle de déviation $\hat{D}$ est prédéterminé suivant les caractéristiques géométriques ou/et physiques du système optique 606. A la sortie du système optique 606, la direction principale du faisceau réalise un angle d'incidence $\hat{I}_1$ sur le masque 603 avec une normale $\vec{n}$ au plan principal du substrat 600. Ensuite, le faisceau de rayons lumineux 602 traverse le masque 603 et sa direction principale $\vec{d}_1$ est à nouveau déviée et réalise un angle incident $\hat{R}_1$ sur la couche de résine 601 avec la normale $\vec{n}$ au plan principal du substrat 600. Ensuite, le faisceau 602 pénètre à travers la couche de résine photosensible 601 et la direction principale $\vec{d}_1$ du faisceau de rayons lumineux 602 est alors à nouveau déviée et réalise un angle résultant d'insolation $\hat{R}_2$ avec la normale $\vec{n}$ au plan principal du substrat 600. La couche de résine photosensible 601 comprend donc des zones insolées 609 inclinées par rapport à la normale au plan principal du substrat 600.

Introduire le système optique 606 apte à dévier la direction principale $\vec{d}_1$ du faisceau de rayons lumineux 602 permet de réduire la différence entre l'angle d'incidence $\hat{I}_1$ sur le masque 603 et l'angle résultant d'insolation $\hat{R}_2$. Le système optique 606 permet donc d'insoler la couche de résine photosensible 601 selon un angle résultant d'insolation $\hat{R}_2$ plus important qu'avec les procédés selon l'art antérieur.

Le système optique 606 peut être avantageusement réalisé dans un matériau dont l'indice de réfraction est proche de celui du masque 603, de façon à ce que le système optique 606 ait un indice de réfraction N proche de l'indice $N_1$ du masque 603. Dans ce cas l'angle d'incident $\hat{R}_1$ sur la couche de résine 601 est quasiment égal à l'angle $\hat{I}_1$ d'incidence sur le masque 603, la direction principale $\vec{d}_1$ du faisceau de rayons lumineux 602 est inchangée lorsque le faisceau 602 traverse le système optique 606 puis lorsque le faisceau 602 traverse le masque 603. En utilisant un système optique 606 et un masque 603 composés du même matériau, on peut donc encore diminuer la différence entre l'angle d'incidence $\hat{I}_1$ et l'angle résultant d'insolation $\hat{R}_2$ et permettre une insolation de la couche de résine photosensible avec un angle résultant d'insolation $\hat{R}_2$ encore plus important.

Après l'étape d'insolation, on ôte le masque 603 et le système optique 606 de la couche de résine photosensible 601. Ensuite, on développe la couche de résine photosensible 601 de façon à obtenir des motifs 607 de résine qui ont des flancs 608 inclinés. Les flancs 608 inclinés des motifs 607 réalisent un angle θ avec une normale $\vec{n}$ au plan principal du substrat 600 (figure 6C). L'angle θ est quasiment égal à l'angle résultant d'insolation $\hat{R}_2$. Le procédé suivant l'invention permet donc d'obtenir des motifs 607 de résine avec un angle θ des flancs 608 de motifs 607, fonction de l'angle de déviation $\hat{D}$ prédéterminé du système optique 606. De plus, l'angle θ des flancs 608 de motifs 607 peut être bien supérieur à celui obtenu avec des procédés selon l'art antérieur.

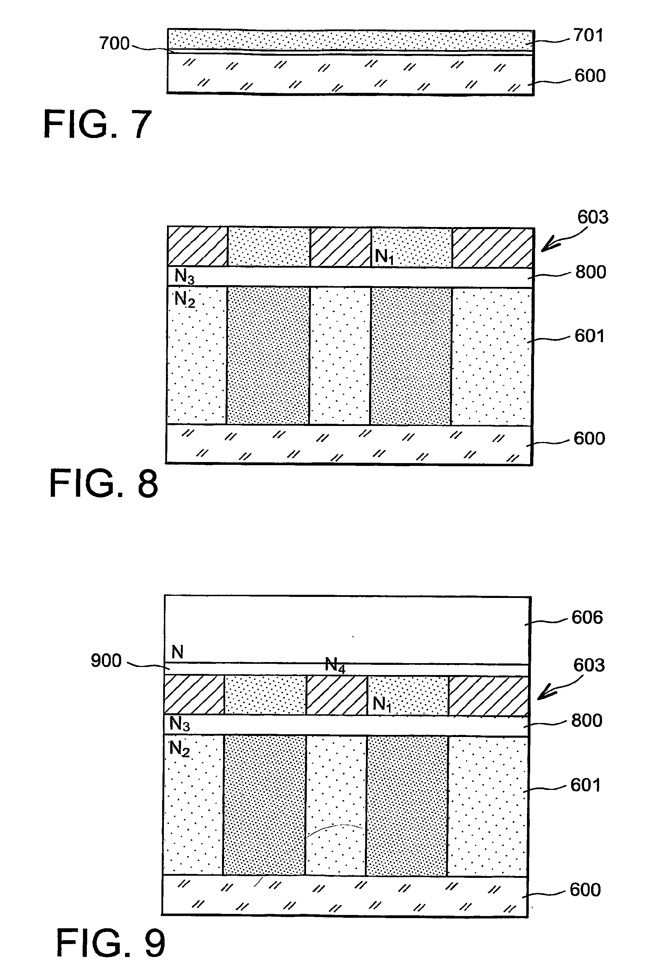

Une variante du procédé selon l'invention, consiste à déposer, avant l'étape de dépôt de la couche de résine photosensible 601 illustrée par la figure 6A, une couche absorbante de rayons lumineux 700 sur le substrat 600. Le dépôt de la couche absorbante 700 de rayons lumineux peut être suivi du dépôt d'une couche de protection 701 qui permet à la couche absorbante 700 de rayons lumineux de ne pas être dissoute par les solvants de la résine 601 du substrat 600 lorsque le substrat 600 est soumis à des contraintes importantes (figure 7). La couche absorbante de rayons lumineux 700 permet d'empêcher la réflexion sur le substrat 600 de rayons ultra-violets, dans le cas d'une photolithographie par rayons ultra-violets. La couche absorbante de rayons lumineux 700 peut être par exemple une couche mince organique de type BARC (BARC étant la terminologie anglo-saxonne pour "Bottom Anti Reflective Coating" qui signifie couche de fond anti-réfléchissant). Son épaisseur peut être par exemple de l'ordre de 80nm. En variante cette couche absorbante de rayons lumineux 700 peut être une résine ou un polymère mélangé à une poudre de carbone ou peut être encore une couche inorganique tel qu'une couche comprenant au moins un empilement $SiO_2/TiO_2$. La couche 701 peut comprendre par exemple un polymère de la famille des élastomères.

Une autre variante du procédé selon l'invention, consiste à déposer, avant la phase d'insolation décrite par la figure 6B, une couche d'adaptation d'indice 800 sur la couche de résine photosensible 601. Cette couche d'adaptation d'indice 800 a un indice de réfraction $N_3$ et est placée entre la couche de résine photosensible 601 et le masque 603 posé par dessus. L'indice de réfraction $N_3$ est proche de l'indice $N_1$ du masque 603 et de l'indice $N_2$ de la couche de résine photosensible 601 entre lesquelles la couche d'adaptation d'indice 800 est placée afin de minimiser les réflexion de Fresnel à l'interface masque 603-couche de résine photosensible 601. Les réflexions de Fresnel sont en effet dues à une fine couche d'air se trouvant inévitablement entre le masque 603 et la couche de résine photosensible 601. La couche d'adaptation d'indice 800 permet alors de remplacer la fine couche d'air d'indice de réfraction égal à 1 par un matériau plus réfringent. On limite donc le saut d'indice provoqué par la fine couche d'air en la remplaçant par la couche d'adaptation d'indice 800 d'indice de réfraction $N_3$ supérieur à 1 et compris entre $N_1$ et $N_2$. La couche d'adaptation d'indice 800 peut prendre la forme d'un gel ou d'un liquide comme de l'eau. On peut la déposer sur la couche de résine photosensible à l'aide par exemple d'une micro-pipette. L'eau a un indice de réfraction environ égal à 1,33 compris entre $N_1$ et $N_2$ et se diffuse par capillarité entre la couche de résine photosensible 601 et le masque 603 que l'on pose par dessus pour former la couche d'adaptation d'indice 800 (figure 8). La couche d'adaptation d'indice 800 peut être également formée à base de glycérine d'indice de réfraction environ égal à 1,47 compris entre $N_1$ et $N_2$ ou d'un liquide gras.

Une autre variante du procédé selon l'invention, consiste, après avoir déposé la couche d'adaptation d'indice 800 et le masque 603, à déposer une autre couche d'adaptation d'indice 900 sur le masque 603 avant l'étape d'insolation décrite par la figure 6B. L'autre couche d'adaptation d'indice 900 vient s'intercaler entre le masque 603 et le système optique 606 que l'on accole ensuite par dessus. Une fine couche d'air se trouve inévitablement entre le masque 603 et le système optique 606. L'autre couche d'adaptation d'indice 900 a un indice de réfraction $N_4$ idéalement compris entre l'indice N du système optique 606 et l'indice $N_2$ de la couche de résine 601. Elle permet de remplacer la fine couche d'air d'indice de réfraction proche de 1, par un matériau plus réfringent. L'autre couche d'adaptation d'indice 900 empêche donc les réflexions de Fresnel entre le masque 603 et le système optique 606 en diminuant le saut d'indice entre le système optique 606 et le masque 603. L'autre couche d'adaptation d'indice 900 peut être constituée par exemple par un liquide tel que l'eau, ou avantageusement par un gel à base de glycérine ou d'un fluide gras déposé sur le masque 603. La glycérine a en outre pour avantage de permettre au système optique 606 de se déplacer par rapport au masque 603 tout en assurant l'adaptation d'indice entre ces deux éléments.

Le fluide ou le liquide que l'on dépose sur le masque 603 est comprimé par le système optique 606 que l'on pose par dessus. Le fluide se diffuse alors par capillarité entre le masque 603 et le système optique 606 pour former l'autre couche d'adaptation d'indice (figure 9).

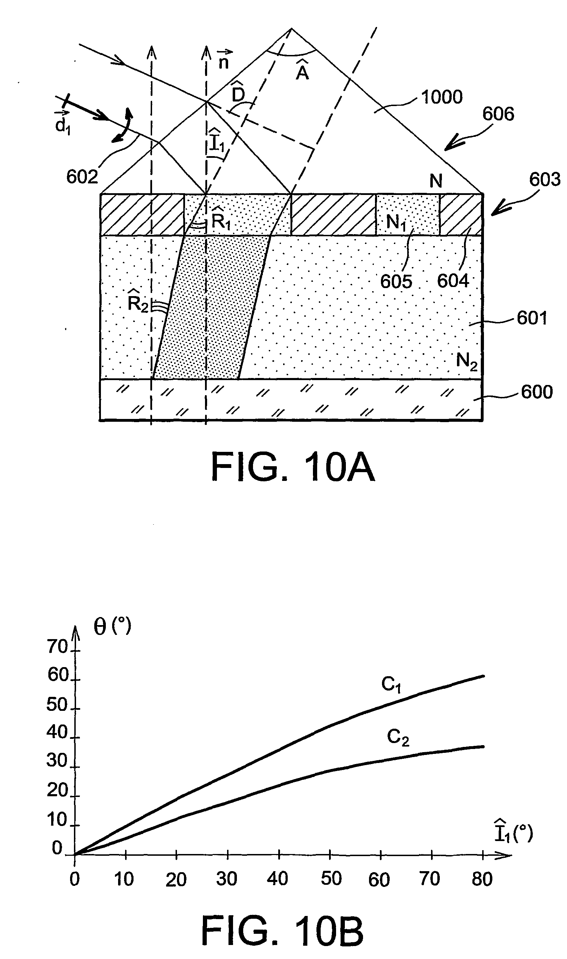

Selon une variante du procédé illustrée par la figure 10A, le système optique 606 utilisé lors de la phase d'insolation décrite par la figure 6B, peut être formé d'un prisme 1000. Le prisme 1000 a un indice de réfraction N, et est taillé à un angle $\hat{A}$ au sommet, qui lui permet de dévier le faisceau de rayons lumineux 602, d'un angle de déviation $\hat{D}$ prédéterminé, fonction de l'indice de réfraction de l'air $N_0$, de son indice de réfraction N, et de son angle au sommet $\hat{A}$.

Le faisceau de rayons lumineux 602 a une direction principale $\vec{d}_1$ et pénètre à travers le prisme 1000 accolé au masque 603 en incidence quelconque. Le prisme 1000 dévie alors la direction principale $\vec{d}_1$ du faisceau de rayons lumineux 602 de l'angle de déviation $\hat{D}$. A la sortie du prisme 1000, la direction principale $\vec{d}_1$ du faisceau 602 réalise un angle d'incidence $\hat{I}_1$ sur le masque 603 avec une normale $\vec{n}$ au plan principal du substrat 600. Ensuite, le faisceau de rayons lumineux 602 traverse le masque 603 et sa direction principale $\vec{d}_1$ est à nouveau déviée et réalise alors un angle incident $\hat{R}_1$ sur la couche de résine 601 avec une normale $\vec{n}$ au plan principal du substrat 600. Ensuite, le faisceau de rayons lumineux 603 pénètre à travers la couche de résine photosensible 601 et la direction principale $\vec{d}_1$ du faisceau de rayons lumineux 602 est à nouveau déviée. La direction principale $\vec{d}_1$ réalise alors un angle résultant d'insolation $\hat{R}_2$ avec la normale $\vec{n}$ au plan principal du substrat 600.

Le prisme 1000 peut être formé d'un matériau minéral ou bien par exemple d'un polymère. De plus, le prisme 1000 peut être avantageusement formé d'un matériau d'indice de réfraction proche de celui du masque 603 ayant donc un indice de réfraction N proche de $N_1$ Le prisme 1000 permet de dévier la direction principale $\vec{d}_1$ du faisceau de rayons lumineux quelle que soit l'incidence du faisceau de rayons lumineux 602 qui le traverse. Ceci implique qu'avec un tel procédé, il n'est pas nécessaire d'incliner le substrat 600 pour insoler la couche de résine photosensible 601 avec un faisceau de rayons lumineux incliné.

Selon une variante de l'exemple de procédé illustrée par la figure 10A, la direction $\vec{d}_1$ du faisceau de rayons lumineux varie au cours de l'étape d'insolation, ce qui entraîne une variation de l'angle d'incidence $\hat{I}_1$ sur le masque 603. Ainsi, on peut faire varier l'angle résultant d'insolation $\hat{R}_2$ de la couche de résine photosensible 601, pendant l'étape d'insolation. Faire varier l'angle résultant d'insolation $\hat{R}_2$ de la couche de résine photosensible 601 permet de réaliser des motifs de résine par photolithographie qui possèdent des flancs inclinés et non-plans.

La figure 10B est un graphe qui représente la

courbe d'évolution $C_1$, dessinée en trait pleins, d'un angle $\theta$ de flancs 608 de motifs 607 obtenus à l'aide d'un procédé utilisant le dispositif décrit par la figure 10A. Le système optique utilisé est un prisme 1000 d'indice de réfraction N égal à 1,46, en fonction de la variation de l'angle d'incidence $\hat{I}_1$ sur le masque 603. La couche de résine photosensible utilisée à un indice de réfraction $N_2$ égal à 1,67. La figure 10B, représente également la courbe d'évolution $C_2$, dessinée en traits pointillés de l'angle $\theta$ des flancs 608 des motifs 607 en fonction de la variation de l'angle $\hat{I}_1$ d'incidence sur le masque 603 obtenus selon un procédé similaire au procédé de l'art antérieur décrit par les figures 6B-6C, mais sans utiliser de système optique. Pour des angles d'incidence $\hat{I}_1$ sur le masque 603 variant de 0° à 50°, $C_1$ et $C_2$ sont croissantes et sensiblement linéaires. La courbe $C_1$ a un taux d'accroissement supérieur à la courbe $C_2$. Pour un angle d'incidence $\hat{I}_1$ sur le masque environ égal à 50°, l'angle $\theta$ des flancs 608 des motifs 607 a par exemple pour valeur environ 28° sur $C_2$ et pour valeur environ 42° sur $C_1$. Ensuite, pour un angle d'incidence $\hat{I}_1$ variant de 50° à 80°, les courbes $C_1$ et $C_2$ croissent pour atteindre un seuil limite vers $\hat{I}_1$ environ égal à 80°. Lorsque l'angle d'incidence $\hat{I}_1$ est égal à 80°, l'angle $\theta$ des flancs 608 des motifs 607 a pour valeur environ 38° sur la courbe $C_2$ et environ 60° sur la courbe $C_1$. La figure 10B montre donc que le procédé décrit par la figure 10A utilisant un prisme 1000 comme système optique permet d'obtenir des motifs par photolithographie qui ont des flancs ayant un angle $\theta$ des flancs 608 des motifs 607 bien supérieur à celui que l'on peut obtenir avec les procédés sans système optique et qui ne dépasse pas 38°.

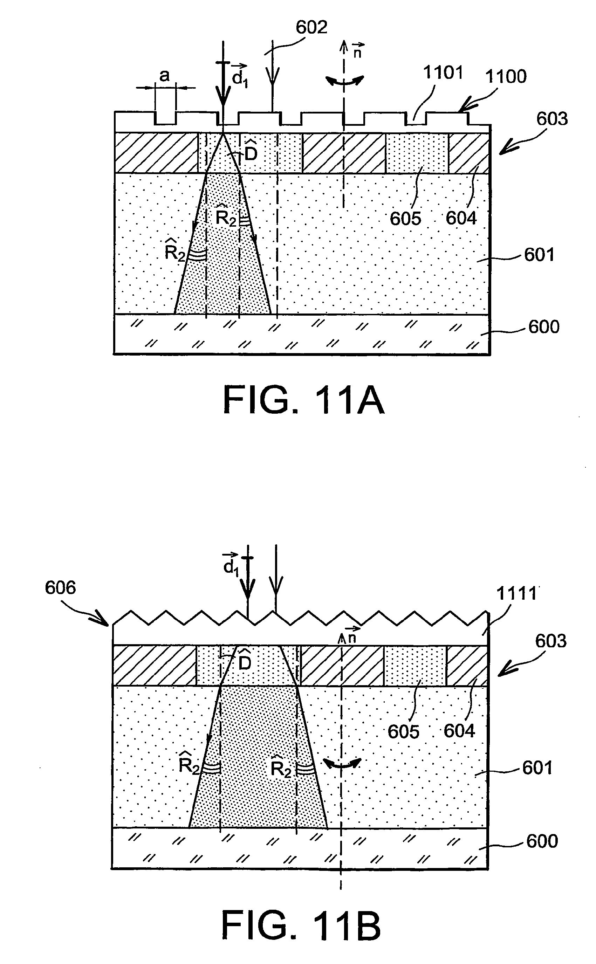

Selon une variante illustrée par la figure 11A de l'exemple de la phase d'insolation du procédé décrit par la figure 6B, le système optique 606 utilisé peut-être formé d'un réseau de diffraction 1100 sous forme d'une plaque, par exemple de verre dans laquelle sont gravées des structures 1101 parallèles de largeur a, ordonnées de façon régulière, a étant de l'ordre de 0,3 $\mu$m par exemple pour un faisceau de rayons lumineux émettant autour de la longueur d'onde 365 nm.

Le réseau de diffraction 1100 permet de dévier la direction principale $\vec{d}_1$ du faisceau de rayons lumineux 602, d'un angle de déviation $\hat{D}$ fonction de la longueur d'onde du faisceau de rayons lumineux 602 et de a. Le réseau de diffraction 1100 permet d'insoler la couche de résine photosensible avec un angle résultant d'insolation $\hat{R}_2$ et un angle $-\hat{R}_2$ fonctions de l'angle de déviation $\hat{D}$.

De plus, la variante illustrée par la figure 11A diffère du procédé de la figure 6B en ce que le réseau de diffraction 1100 associé au masque 603 tournent sur eux-même pendant l'étape d'insolation alors que la couche de résine photosensible 601 et le substrat 600 restent immobiles.

Selon une variante illustrée par la figure 11B de l'exemple d'étape d'insolation du procédé illustré par la figure 6B, le système optique utilisé peut comprendre un réseau de micro-prismes 1111. Un réseau de micro-prismes peut se présenter sous forme d'une plaque transparente au faisceau de rayons lumineux recouverte de micro-prismes répartis de façon régulière sur la plaque. Le réseau de micro-prismes 1111 peut être réalisé dans un matériau par exemple à base de verre, de silice ou d'un polymère. Le réseau de micro-prismes 1111 a un fonctionnement similaire au réseau de diffraction 1100 illustré par la figure 11A. En effet, le réseau de micro-prismes 1111 permet de dévier la direction principale $\vec{d}_1$ du faisceau de rayons lumineux 602, d'un angle de déviation $\hat{D}$. Le réseau de micro-prismes 1111 permet donc d'insoler la couche de résine photosensible avec un angle résultant d'insolation $\hat{R}_2$ fonction de l'angle de déviation $\hat{D}$.

De plus, la variante illustrée par la figure 11B diffère du procédé de la figure 6B en ce que le masque 603 associé à la couche de résine photosensible 601 et au substrat 600 tourne sur lui même alors que le réseau de micro-prismes 1111 reste immobile pendant l'étape d'insolation.

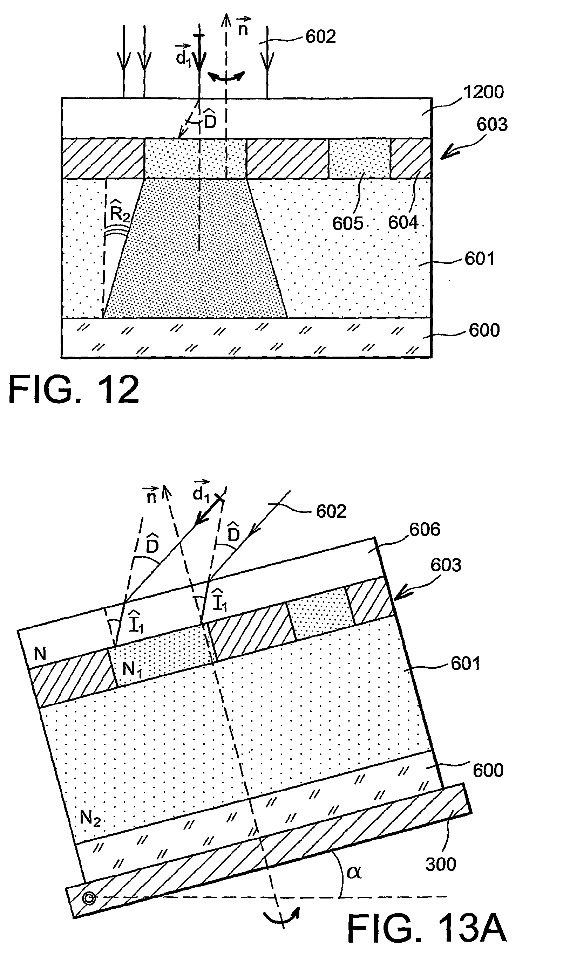

Selon une variante illustrée par la figure 12 de l'exemple de la phase d'insolation du procédé décrit par la figure 6B, le système optique 606 utilisé peut-être formé d'un diffuseur optique 1200 d'indice N qui permet de dévier le faisceau de rayons lumineux 602, d'un angle de déviation $\hat{D}$ prédéterminé fonction de N. Le diffuseur optique 1200 a pour avantage d'être plane et donc d'être intégrable aisément à un dispositif de photolithographie qui permet d'insoler la couche de résine photosensible avec un angle résultant d'insolation $\hat{R}_2$ fonction de l'angle de déviation $\hat{D}$. Le diffuseur optique 1200 peut être par exemple une simple lame en verre.

La figure 13A représente un exemple de dispositif de réalisation de motifs à flancs inclinés par photolithographie. Le dispositif comprend un substrat 600 sur lequel repose une couche de résine photosensible 601 d'indice de réfraction $N_2$, un masque 603 d'indice de réfraction $N_1$ accolé à la couche de résine photosensible 601, un système optique 606 d'indice de réfraction N accolé au masque 603. Le dispositif comprend également un faisceau de rayons lumineux 602 de direction principale $\vec{d}_1$ qui sert à insoler la couche de résine photosensible 601 à travers le masque 603. Le dispositif comprend également un plateau 1300 apte à adopter un angle d'inclinaison $\alpha$ variable et éventuellement à tourner sur lui-même sur lequel repose le substrat 600. Le système optique 606 est apte à dévier la direction principale $\vec{d}_1$, quelle que soit la direction $\vec{d}_1$ du faisceau de rayons lumineux 602 qui le traverse, d'un angle de déviation $\hat{D}$ prédéterminé de sorte que la direction principale $\vec{d}_1$ peut être inclinée par rapport à une normale $\vec{n}$ au plan principal du substrat 600 au moment de pénétrer à travers la couche de résine photosensible 601. Le faisceau de rayons lumineux 602 est issu d'une source de rayons lumineux (non représentée sur la figure 13A) par exemple une source de rayons ultra-violets. Le système optique 606 est réalisé dans un matériau transparent à la longueur d'onde de la source. Le système optique 606 est par exemple réalisé dans un matériau à base de silice ou à base d'un polymère. Le masque 603 peut être également formé par un matériau à base de silice ou à base d'un polymère.

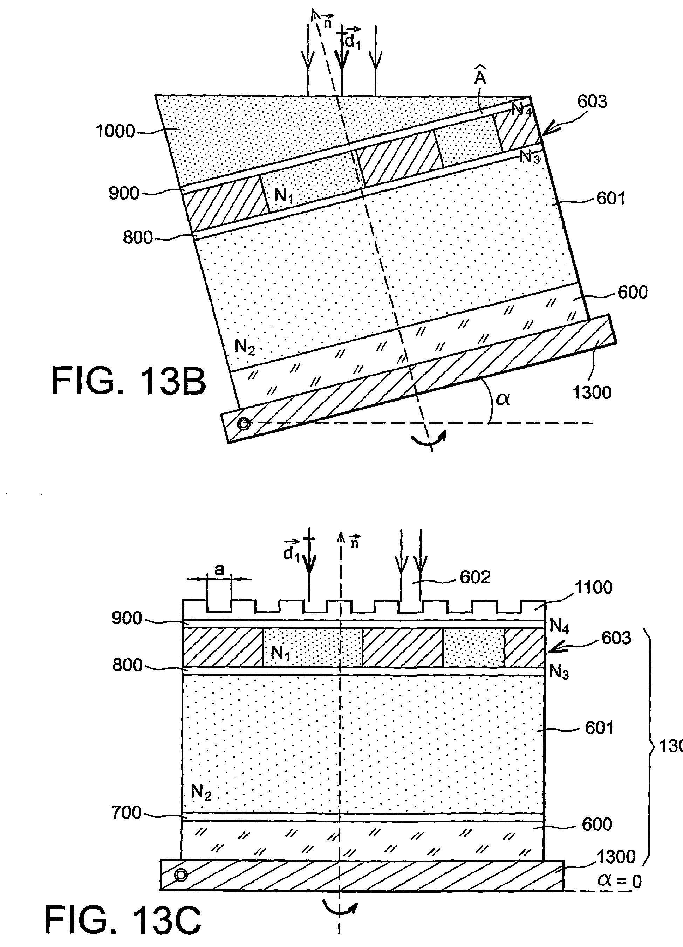

La figure 13B représente un autre exemple de dispositif suivant l'invention et qui diffère de celui de la figure 13A en ce que, le système optique est un prisme 1000 taillé à un angle $\hat{A}$. Le prisme 1000 est fixe par rapport à une ensemble 1301 constitué par le masque 603, la couche de résine photosensible 601, le substrat 600 et le plateau 1300. Le plateau 1300 est apte à adopter un angle d'inclinaison $\alpha$ sensiblement égal à $\hat{A}$ et à tourner sur lui-même, de manière à faire tourner l'ensemble 1201 sur lui même. Incliner le plateau 1300 d'un angle $\alpha$ sensiblement égal à l'angle $\hat{A}$ permet d'avoir un faisceau de rayon lumineux 602 normal au prisme 1000 et d'insoler la couche de résine photosensible 601 avec le maximum d'intensité lumineuse. Le prisme 1000 est formé du même matériau que le masque 603, par exemple d'un matériau à base de polymère et est accolé au masque 603. Le prisme a un indice de réfraction N égal à l'indice de réfraction $N_1$ du masque. De plus, le prisme 1000 est taillé à un angle $\hat{A}$ qui permet de dévier le faisceau de rayons lumineux 602, d'un angle de déviation $\hat{D}$ prédéterminé fonction de l'indice de l'air $N_0$, de l'indice de réfraction du prisme N, et de l'angle $\hat{A}$. D'autre part le dispositif de la figure 13B diffère également de celui de la figure 13A en ce qu'il comprend une première couche d'adaptation d'indice 800 située entre la couche de résine photosensible 601 et le masque 603 et qui a un indice de réfraction $N_3$. La première couche d'adaptation d'indice 800 est par exemple de l'eau ou un liquide gras comme la glycérine dont l'indice de réfraction $N_3$ est proche de celui $N_1$ du masque et de celui $N_2$ de la couche de résine photosensible 601. Cette première couche d'adaptation d'indice 800 permet de minimiser les réflexions de Fresnel entre le masque 603 et la couche de résine photosensible 601. Le dispositif de la figure 13B diffère également de celui de la figure 13A en ce qu'il comprend en outre une deuxième couche d'adaptation d'indice 900 ayant un indice de réfraction $N_4$. La deuxième couche d'adaptation d'indice 900 est par exemple de l'eau ou un fluide gras tel que la glycérine. La deuxième couche d'adaptation d'indice 900 est située entre le masque 603 et le système optique 606. La deuxième couche d'adaptation d'indice 900 a un indice de réfraction $N_4$ proche de l'indice N du système optique 606 et de l'indice $N_1$ du masque 603.

L'adjonction des couches d'adaptation d'indice 800 et 900 permet, en minimisant la présence d'air entre le système optique 606 et le masque 603 d'une part et entre le masque 603 et la couche de résien 601 d'autre part, d'obtenir des angles d'inclinaison des flancs des motifs de résine supérieurs à ceux obtenus dans l'art antérieur.

Le dispositif de la figure 13B diffère enfin de celui de la figure 13A, en ce qu'il comprend une couche absorbante de rayons lumineux 700, située entre le substrat 600 et la couche de résine photosensible 601. La couche absorbante de rayons lumineux 700 sert à empêcher les rayons ultra-violets de se réfléchir sur le substrat dans le cas où le faisceau de rayons lumineux 602 est issu d'une source de lumière ultra-violette. La couche absorbante de rayons lumineux 700 peut être formée d'une seule couche ou d'un empilement de sous-couches. La couche absorbante de rayons lumineux 700 peut être par exemple une résine mélangée à des pigments de carbone.

La figure 13C représente un autre exemple de dispositif suivant l'invention et qui diffère de celui de la figure 13B en ce que le système optique est un réseau de diffraction 1100. De plus, le réseau de diffraction 1100 est mobile par rapport à un premier ensemble 1301 formé par le masque 603, la couche de résine photosensible 601, le substrat 600 et le plateau 1300. Enfin, le plateau 1300 a un angle d'inclinaison $\alpha$ nul. Il est apte à tourner sur lui même.

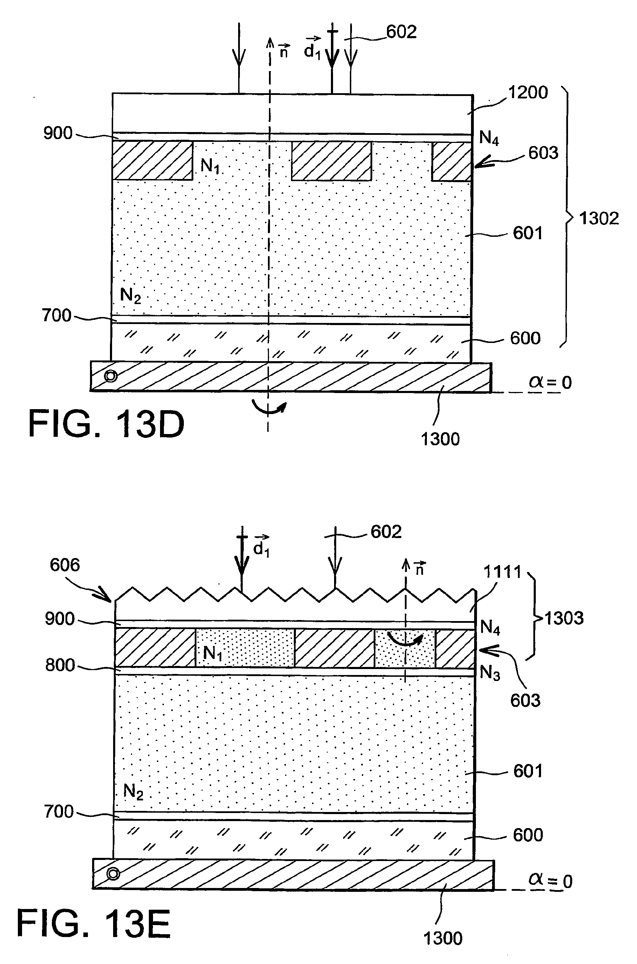

La figure 13D représente un autre exemple de dispositif suivant l'invention et qui diffère de celui de la figure 13A en ce que le système optique est un diffuseur optique 1200. Le diffuseur optique 1200, le masque 603, la couche de résine photosensible 601, le substrat 600, et le plateau 1300 forment un deuxième ensemble 1302 susceptible de tourner sur lui même et mobile par rapport au faisceau de rayons lumineux 602.

Le dispositif diffère également en ce que le masque 603, par exemple une couche de chrome gravée, est directement intégré à la couche de résine photosensible 601. Dans ce cas l'indice du masque $N_1$ est égal à celui de la résine $N_2$. Le dispositif comprend également une couche absorbante de rayons lumineux 700, située entre le substrat 600 et la couche de résine photosensible 601 et une couche d'adaptation d'indice 900 qui a un indice de réfraction $N_4$. Enfin, le plateau 1300 a un angle d'inclinaison $\alpha$ nul.

La figure 13E représente un autre exemple de dispositif suivant l'invention et qui diffère de celui de la figure 13A en ce que le système optique est un réseau de micro-prismes 1111. Le réseau de micro-prismes 1111 associé au masque 603, forment un troisième ensemble 1303 susceptible de tourner sur lui même par rapport à la couche de résine photosensible 601 au substrat 600 et au plateau 1300. Le troisième ensemble 1303 est également mobile par rapport au faisceau de rayons lumineux 602. Enfin, le plateau 1300 a un angle d'inclinaison $\alpha$ nul.

Documents cités

[1] : "Microfabrication of 3D Multidirectional Inclined Structures by UV Lithography and Electroplating"; C. Beuret, G.-A Racine, J. Gobet, R. Luthier, N.F. de Rooij ; asulab S.A. Neuchatel Switzerland ; 1994 IEEE ©

[2] : "Procédé de fabrication de micro éléments de connexion de forme conique" ; T, IEE Japan vol.122-E n°2 ; 13 09 2002.

[3] : "Application of Shadow Mask and Polarized Inclined-Exposure for Curved SU-8 Structures on Inclined Surface" ; Kuo-Yung Hung, Fan-Gang Tseng from the Department of Engineerig and System Science of Tsing Hua University in Taiwan, présenté durant la conférence HAMST 2003 à Montrerey California USA, 15-17 Juin 2003.

[4] : "Sloped irradiation Techniques in Deep X-Ray Lithography for 3-D shaping of Micro-structures" ; Gregor feiertag, Wolfgang Ehrfeld, Heinz Lehr, Martin Schmidt ; Institute of Microtechnology Mainz Gmbh, Carl-Zeiss-Straße 55219 Mainz, Germany ; © 1997 SPIE.

[5] : "Multi-level Micro-structures and Mold Inserts Fabricated with Planar and Oblique X-ray Lithography of SU-8 Négative Photoresist ; Linke Jian, Yohanes M.Desta, Jost Goettert ; Louisiana State University Center for Advanced Micro-structures and Devices ; © 2001 SPIE.

## Revendications

**1.** Procédé de réalisation d'un ou plusieurs motifs par photolithographie comprenant les étapes suivantes :

a) dépôt sur un substrat (600) d'une couche de résine photosensible (601),
ledit procédé étant **caractérisé en ce qu'**il comprend les étapes suivantes :
b) insolation de la couche de résine photosensible (601) à travers un masque (603) accolé à ladite couche de résine photosensible ou à une couche d'adaptation d'indice accolée à ladite couche de résine, par un faisceau de rayons lumineux (602) ayant une direction principale $(\vec{d}_1)$, le faisceau de rayons lumineux (602) ayant traversé auparavant un système optique (606) accolé audit masque ou à une couche d'adaptation d'indice accolée audit masque, qui dévie la direction principale $(\vec{d}_1)$ du faisceau de rayons lumineux (602) d'un angle de déviation $(\hat{D})$ prédéterminé de sorte que la direction principale $(\vec{d}_1)$ présente un angle d'incidence $(\hat{I}_1)$ sur le masque (603) non nul avec une normale $(\vec{n})$ au plan principal du substrat (600) lorsque le faisceau de rayons lumineux (602) pénètre à travers le masque (603),
c) retrait du masque (603),
d) développement de la couche de résine photosensible (601) de façon à obtenir les motifs à flancs inclinés par rapport à une normale $(\vec{n})$ au plan principal du substrat (600) en fonction de l'angle de déviation $(\hat{D})$ prédéterminé.

**2.** Procédé selon la revendication 1, **caractérisé en ce que** l'étape de dépôt de la couche de résine photosensible (601) est précédée d'une étape de dépôt d'au moins une couche absorbante (700) des rayons lumineux.

**3.** Procédé selon l'une des revendication 1 ou 2, **caractérisé en ce qu'**après l'étape a) de dépôt de la couche de résine photosensible (601), une couche d'adaptation d'indice (800) est déposée sur la couche de résine photosensible (601).

**4.** Procédé selon l'une des revendications 1 à 3, **caractérisé en ce qu'**avant l'étape d'insolation de la couche de résine photosensible (601), une couche d'adaptation d'indice (900) est placée entre le système optique (606) et le masque (603).

**5.** Procédé selon l'une des revendication 1 à 4 **caractérisé en ce que** le système optique (606) comprend un prisme (1000), un réseau de diffraction (1100), un diffuseur optique (1200), ou un réseau de microprismes (1111).

**6.** Procédé selon l'une des revendications 1 à 5, **caractérisé en ce que** pendant l'étape b) d'insolation, l'angle d'incidence $(\hat{I}_1)$ sur le masque (603) varie.

**7.** Procédé selon l'une des revendications 1 à 6, **caractérisé en ce que** pendant l'étape b) d'insolation d'une part le système optique (606) et d'autre part le substrat (600) sont animés d'un mouvement relatif l'un par rapport à l'autre, le masque (603) étant associé soit au système optique (606), soit au substrat (600).

**8.** Procédé selon l'une des revendications 1 à 6, **caractérisé en ce que** pendant l'étape b) d'insolation

un ensemble formé du système optique (606) du masque (603), et du substrat (600) est animé d'un mouvement relatif par rapport au faisceau de rayons lumineux (602).

9. Dispositif de réalisation d'un ou plusieurs motifs inclinés par photolithographie, comprenant un substrat (600) sur lequel repose une couche de résine photosensible (601) d'indice de réfraction ($N_2$), **caractérisé en ce qu'**il comporte en outre un masque (603) d'indice de réfraction ($N_1$) accolé à ladite couche de résine photosensible ou à une couche d'adaptation d'indice reposant sur ladite couche de résine, un système optique (606) accolé au masque ou à une couche d'adaptation d'indice reposant sur le masque, des moyens pour insoler la couche de résine photosensible (601) à l'aide d'un faisceau de rayons lumineux (602) de direction principale $(\vec{d}_1)$, le système optique (606) étant apte à dévier d'un angle de déviation ($\hat{D}$) prédéterminé la direction principale $(\vec{d}_1)$ du faisceau de rayons lumineux de sorte que la direction principale $(\vec{d}_1)$ présente un angle d'incidence ($\hat{I}_1$) sur le masque (603) non nul avec une normale $(\vec{n})$ au plan principal du substrat (600) au moment où le faisceau de rayons lumineux (602) pénètre à travers le masque (603).

10. Dispositif selon la revendication 9, dans lequel le masque (603) comporte une ou plusieurs ouvertures (605) **caractérisé en ce que** le système optique (606) et les ouvertures (605) du masque (603) ont des indices de réfraction proches.

11. Dispositif selon la revendication 9, dans lequel le masque (603) comporte une ou plusieurs ouvertures (605) **caractérisé en ce que** le système optique (606) et les ouvertures (605) du masque (603) sont réalisés dans le même matériau.

12. Dispositif selon l'une des revendications 9 à 11 **caractérisé en ce que** le masque (603) est intégré à la couche de résine photosensible (601).

13. Dispositif selon l'une des revendications 9 à 12 **caractérisé en ce que** le système optique (606) comprend un prisme (1000), un réseau de diffraction (1100), un réseau de micro-prismes (1111) ou un diffuseur optique (1200).

14. Dispositif selon l'une de la revendication 9 à 13 **caractérisé en ce qu'**il comprend une couche d'adaptation d'indice (800) entre la couche de résine photosensible (601) et le masque (603).

15. Dispositif selon l'une des revendications 9 à 14 **caractérisé en ce que** le dispositif comprend une couche d'adaptation d'indice (900) entre le système optique (606) et le masque (603).

16. Dispositif selon l'une des revendications 14 ou 15 **caractérisé en ce que** la couche d'adaptation (800) située entre la couche de résine photosensible (601) et le masque (603) ou/et la couche d'adaptation (900) située entre le système optique (606) et le masque (603) est un liquide tel que l'eau ou un fluide gras.

17. Dispositif selon l'une des revendications 9 à 16 **caractérisé en ce qu'**il comprend une couche absorbante de rayons lumineux (700) entre le substrat (600) et la couche de résine photosensible (601).

18. Dispositif selon l'un des revendications 9 à 17, **caractérisé en ce que** le système optique (606) est mobile relativement au substrat (600), le masque (603) étant associé soit au système optique (606) soit au substrat (600).

19. Dispositif selon l'un des revendications 9 à 18, **caractérisé en ce qu'**il comprend un plateau (1300), sur lequel repose le substrat (600), mobile en rotation par rapport au faisceau de rayons lumineux (602).

20. Dispositif selon l'une des revendications 9 à 19, **caractérisé en ce qu'**il comprend un plateau (1300) sur lequel repose le substrat (600), inclinable par rapport au faisceau de rayons lumineux (602).

**Claims**

1. Method for producing one or more patterns by photolithography comprising the following steps:

   a) deposit on a substrate (600) of a photosensitive resin layer (601), said method being **characterized in that** it comprises the following steps:
   b) insolation of the photosensitive resin layer (601) through a mask (603) joined to said photosensitive resin layer or to a layer of index adaptation joined to said layer of resin, by a light beam (602) having a main direction $(\vec{d}_1)$, the light beam (602) having previously passed through an optical system (606) joined to said mask or to a layer of index adaptation joined to said mask, which deflects the main direction $(\vec{d}_1)$ of the light beam (602) by a predetermined angle of deviation ($\hat{D}$) such that the main

direction $(\vec{d_1})$ presents a non-zero angle of incidence $(\hat{I}_1)$ on the mask (603) with a normal $(\vec{n})$ relative to the principal plane of the substrate (600) when the light beam (602) penetrates the mask (603),

c) withdrawal of the mask (603),

d) development of the photosensitive resin layer (601) so as to produce patterns with inclined flanks relative to a normal $(\vec{n})$ relative to principal plane of the substrate (600) as a function of the predetermined angle of deviation $(\hat{D})$.

2. Method according to claim 1, **characterized in that** the step of depositing the photosensitive resin layer (601) is preceded by a step of depositing at least one light beam absorbing layer (700).

3. Method according to claim 1 or 2, **characterized in that** after the step a) of deposit of the photosensitive resin layer (601), a layer (800) of index adaptation is deposited on the photosensitive resin layer (601).

4. Method according to one of the claims 1 to 3, **characterized in that** before the step of insolating the photosensitive resin layer (601), a layer (900) of index adaptation is placed between the optical system (606) and the mask (603).

5. Method according to one of the claims 1 to 4, **characterized in that** the optical system (606) comprises a prism (1000), a diffraction grating (1100), an optical diffuser (1200), or an array of micro-prisms (1111).

6. Method according to one of the claims 1 to 5, **characterized in that** during the insolation step b) the angle of incidence $(\hat{I}_1)$ on the mask (603) varies.

7. Method according to one of the claims 1 to 6, **characterized in that** during the insolation step b) on the one hand the optical system (606) and on the other hand the substrate (600) are made to move relative to one another, the mask (603) being associated either with the optical system (606), or with the substrate (600).

8. Method according to one of the claims 1 to 7, **characterized in that** during the insolation step b) an assembly formed by the optical system (606), the mask (603), and the substrate (600) is made to move relative to the light beam (602).

9. Device for producing one or more inclined patterns by photolithography, comprising a substrate (600) on which rests a photosensitive resin layer (601) of refraction index $(N_2)$, **characterized in that** it also comprises a mask (603) of refraction index $(N_1)$ joined to said photosensitive resin layer or to a layer of index adaptation resting on said layer of resin, an optical system (606) joined to the mask or to a layer of index adaptation resting on the mask, means for insolating the photosensitive resin layer (601) by means of a light beam (602) of main direction $(\vec{d_1})$, the optical system (606) being capable of deflecting by a predetermined angle of deviation $(\hat{D})$ the main direction $(\vec{d_1})$ of the light beam, such that the main direction $(\vec{d_1})$ makes a non-zero angle of incidence $(\hat{I}_1)$ on the mask (603) with a normal relative to the principal plane of the substrate (600) at the moment when the light beam (602) penetrates the mask (603).

10. Device according to claim 9, in which the mask (603) comprises one or more openings (605), **characterized in that** the optical system (606) and the openings (605) of the mask (603) have close indices of refraction.

11. Device according to claim 9, in which the mask (603) comprises one or more openings (605), **characterized in that** the optical system (606) and the openings (605) of the mask (603) are made of the same material.

12. Device according to one of the claims 9 to 11, **characterized in that** the mask (603) is integrated into the photosensitive resin layer (601).

13. Device according to one of the claims 9 to 12, **characterized in that** the optical system (606) comprises a prism (1000), a diffraction grating (1100), an array of micro-prisms (1111) or an optical diffuser (1200).

14. Device according to one of the claims 9 to 13, **characterized in that** it comprises a layer of index adaptation (800) between the photosensitive resin layer (601) and the mask (603).

15. Device according to one of the claims 9 to 14, **characterized in that** the device comprises a layer (900) of index adaptation between the optical system (606) and the mask (603).

16. Device according to claim 14 or 15, **characterized in that** the adaptation layer (800) situated between the photosensitive resin layer (601) and the mask (603) and/or the adaptation layer (900) situated between the optical system (606) and the mask (603) is a liquid such as water or a fatty fluid.

17. Device according to one of the claims 9 to 16, **char-**

**acterized in that** it comprises a light beam absorbing layer (700) between the substrate (600) and the photosensitive resin layer (601).

18. Device according to one of the claims 9 to 17, **characterized in that** the optical system (606) is mobile relative to the substrate (600), the mask (603) being associated either with the optical system (606) or the substrate (600).

19. Device according to one of the claims 9 to 18, **characterized in that** it comprises a plate (1300), on which rests the substrate (600), mobile in rotation relative to the light beam (602).

20. Device according to one of the claims 9 to 19, **characterized in that** it comprises a plate (1300) on which rests the substrate (600), inclinable relative to the light beam (602).

**Patentansprüche**

1. Verfahren zur Herstellung von einem oder mehreren Mustern mittels Fotolithographie, das die folgenden Schritte umfasst:

a) Abscheiden einer Fotoresistschicht (601) auf einem Substrat (600),
wobei das Verfahren **dadurch gekennzeichnet ist, dass** es die folgenden Schritte umfasst:
b) Belichten der Fotoresistschicht (601) mittels eines Lichtstrahlenbündels (602) mit einer Hauptrichtung $\left(\vec{d_1}\right)$ durch eine Maske (603) hindurch, die mit der genannten Fotoresistschicht oder mit einer mit der genannten Fotoresistschicht verbundenen Indexanpassungsschicht verbunden ist, wobei das Lichtstrahlenbündel (602) vorher ein optisches System (606) durchquert hat, das mit der genannten Maske oder mit einer mit der genannten Maske verbunden Indexanpassungsschicht verbunden ist, welche die Hauptrichtung $\left(\vec{d_1}\right)$ des Lichtstrahlenbündels (602) um einen Ablenkwinkel $(\hat{D})$ ablenkt, der vorher so festgelegt wird, dass - wenn das Lichtstrahlenbündel (602) die Maske (603) durchquert -, die Hauptrichtung $\left(\vec{d_1}\right)$ auf der Maske (603) mit einer Normalen $(\hat{n})$ zur Hauptebene des Substrats (600) einen Nichtnull-Einfallwinkel $(\hat{I}_1)$ bildet,
c) Entfernen bzw. Rückätzen der Maske (603),
d) Entwickeln der Fotoresistschicht (601), um Muster mit Flanken herzustellen, die in Abhängigkeit von dem vorher festgelegten Ablenkwinkel $(\hat{D})$ geneigt sind in Bezug auf eine Normale $(\hat{n})$ zur Hauptebene des Substrats (600).

2. Verfahren nach Anspruch 1, **dadurch gekennzeichnet, dass** dem Schritt zur Abscheidung der Fotoresistschicht (601) ein Schritt zur Abscheidung von wenigstens einer Absorptionsschicht (700) der Lichtstrahlen vorausgeht.

3. Verfahren nach einem der Ansprüche 1 oder 2, **dadurch gekennzeichnet, dass** nach dem Schritt a) zum Abscheiden der Fotoresistschicht (601) auf der Fotoresistschicht (601) eine Indexanpassungsschicttt (800) abgeschieden wird.

4. Verfahren nach einem der Ansprüche 1 bis 3, **dadurch gekennzeichnet, dass** vor dem Belichtungsschritt der Fotoresistschicht (601) zwischen dem optischen System (606) und der Maske (603) eine Indexanpassungsschicht (900) realisiert wird.

5. Verfahren nach einem der Ansprüche 1 bis 4, **dadurch gekennzeichnet, dass** das optische System (606) ein Prisma (1000), ein Beugungsgitter (1100), einen optischen Diffusor (1200) oder ein Mikroprismengitter (1111) umfasst.

6. Verfahren nach einem der Ansprüche 1 bis 5, **dadurch gekennzeichnet, dass** während des Belichtungsschritts b) der Einfallwinkel $(\hat{I}_1)$ auf die Maske (603) variiert.

7. Verfahren nach einem der Ansprüche 1 bis 6, **dadurch gekennzeichnet, dass** während des Belichtungsschritts b) einerseits das optische System (606) und andererseits das Substrat (600) in gegenseitige Relativbewegungen versetzt werden, wobei die Maske (603) entweder mit dem optischen System (606) oder mit dem Substrat (600) verbunden ist.

8. Verfahren nach einem der Ansprüche 1 bis 6, **dadurch gekennzeichnet, dass** während des Belichtungsschritts b) eine durch das optische System (606), die Maske (603) und das Substrat (600) gebildete Einheit in eine Relativbewegung in Bezug auf das Lichtstrahlenbündel (602) versetzt wird.

9. Vorrichtung zur Herstellung von einem oder von mehreren geneigten Mustern mittels Fotolithographie, ein Substrat (600) umfassend, auf dem eine Fotoresistschicht (601) mit einem Brechindex $(N_2)$ ruht, **dadurch gekennzeichnet, dass** sie außerdem eine Maske (603) mit Brechindex $(N_1)$, verbunden mit der genannten Fotoresistschicht oder mit einer auf der genannten Fotoresistschicht ruhenden Indexanpassungsschicht, ein optisches System (606), verbunden mit der Maske oder mit einer auf der Maske ruhenden Indexanpassungsschicht und Einrichtungen zum Belichten der Fotoresistschicht (601) mit Hilfe eines Lichtstrahlenbündels (602) mit der Hauptrichtung $(\vec{d_1})$ umfasst, wobei das optische System (606) fähig ist, die Hauptrichtung des Lichtstrahlenbündels um einen vorher so festgelegten Ablenkwinkel ($\hat{D}$) abzulenken, dass in dem Moment, wo das Lichtstrahlenbündel (602) in die Maske (603) eindringt, die Hauptrichtung $(\vec{d_1})$ auf der Maske (603) mit einer Normalen ($\hat{n}$) zur Hauptebene des Substrats (600) einen Nichtnull-Einfallwinkel ($\hat{I}_1$) bildet.

10. Vorrichtung nach Anspruch 9, bei der die Maske (603) eine oder mehrere Öffnungen (605) aufweist, **dadurch gekennzeichnet, dass** das optische System (606) und die Öffnungen (605) der Maske (603) ähnliche Brechindizes haben.

11. Vorrichtung nach Anspruch 9, bei der die Maske (603) eine oder mehrere Öffnungen (605) aufweist, **dadurch gekennzeichnet, dass** das optische System (606) und die Öffnungen (605) der Maske (603) in dem gleichen Material realisiert sind.

12. Vorrichtung nach einem der Ansprüche 9 bis 11, **dadurch gekennzeichnet, dass** die Maske (603) in die Fotoresistschicht (601) integriert ist.

13. Vorrichtung nach einem der Ansprüche 9 bis 12, **dadurch gekennzeichnet, dass** das optische System (606) ein Prisma (1000), ein Beugungsgitter (1100), ein Mikroprismengitter (1111) oder einen optischen Diffusor (1200) umfasst.

14. Vorrichtung nach einem der Ansprüche 9 bis 13, **dadurch gekennzeichnet, dass** sie eine Indexanpassungsschicht (800) zwischen der Fotoresistschicht (601) und der Maske (603) umfasst.

15. Vorrichtung nach einem der Ansprüche 9 bis 14, **dadurch gekennzeichnet, dass** die Vorrichtung eine Indexanpassungsschicht (900) zwischen dem optischen System (606) und der Maske (603) umfasst.

16. Vorrichtung nach einem der Ansprüche 14 oder 15, **dadurch gekennzeichnet, dass** die Anpassungsschicht (800) zwischen der Fotoresistschicht (601) und der Maske (603) und/oder die Anpassungsschicht (900) zwischen dem optischen System (606) und der Maske (603) eine Flüssigkeit wie Wasser oder ein fettes Fluid ist.

17. Vorrichtung nach einem der Ansprüche 9 bis 16, **dadurch gekennzeichnet, dass** sie eine Lichtstrahlen absorbierende Schicht (700) zwischen dem Substrat (600) und der Fotoresistschicht (601) umfasst.

18. Vorrichtung nach einem der Ansprüche 9 bis 17, **dadurch gekennzeichnet, dass** das optische System (606) in Bezug auf das Substrat (600) beweglich ist, wobei die Maske (603) entweder mit dem optischen System (606) oder dem Substrat (600) verbunden ist.

19. Vorrichtung nach einem der Ansprüche 9 bis 18, **dadurch gekennzeichnet, dass** sie eine in Bezug auf das Lichtstrahlenbündel (602) drehbare Grundplatte (1300) umfasst, auf der das Substrat (600) ruht.

20. Vorrichtung nach einem der Ansprüche 9 bis 19, **dadurch gekennzeichnet, dass** sie eine in Bezug auf das Lichtstrahlenbündel (602) neigbare Grundplatte (1300) umfasst, auf der das Substrat (600) ruht.

FIG. 1A

FIG. 1B

FIG. 1C

FIG. 2A

FIG. 2B

FIG. 3A

FIG. 3B

FIG. 3C

FIG. 4

FIG. 5

FIG. 6A

FIG. 6B

FIG. 6C

700 — 701
600

FIG. 7

603
N_1 — 800
N_3
N_2 — 601
600

FIG. 8

606
N — 603
900 — N_4
N_1 — 800
N_3
N_2 — 601
600

FIG. 9

# FIG. 10A

# FIG. 10B

FIG. 11A

FIG. 11B

FIG. 12

FIG. 13A

FIG. 13B

FIG. 13C

FIG. 13D

FIG. 13E